# FASCICULE DE BREVET EUROPEEN

(11) **EP 2 229 689 B1**
(45) Date de publication et mention de la délivrance du brevet: **16.11.2016**
(21) Numéro de dépôt: 08863510.7
(22) Date de dépôt: 15.12.2008
(51) Int. Cl.: H01L 21/20

(54) **PROCEDE D'HETERO EPITAXIE LOCALISEE SUR DIELECTRIQUE, EN PARTICULIER DE GERMANIUM SUR SILICIUM OXYDE, ET PROCEDE DE REALISATION D'UNE BASE DE FABRICATION DE CIRCUIT INTEGRE HOMOGENE OU HETEROGENE**
VERFAHREN FÜR LOKALISIERTE HETEROEPITAXIE AUF EINEM DIELEKTRIKUM, IM BESONDEREN VON GERMANIUM AUF OXIDIERTEM SILICIUM, SOWIE VERFAHREN ZUR HERSTELLUNG EINER PRODUKTIONSBASIS EINER HOMOGENEN ODER HETEROGENEN INTEGRIERTEN SCHALTUNG
METHOD FOR LOCALISED HETERO-EPITAXY ON A DIELECTRIC, IN PARTICULAR OF GERMANIUM ON OXIDISED SILICON, AND METHOD FOR MAKING A PRODUCTION BASE OF A HOMOGENEOUS OR HETEROGENEOUS INTEGRATED CIRCUIT

(30) Priorité: 14.12.2007 FR 0759859
(43) Date de publication de la demande: 22.09.2010
(73) Titulaire: Universite Paris-Sud, 91400 Orsay (FR); Centre National de la Recherche Scientifique, 75016 Paris (FR)
(72) Inventeur: BOUCHIER, Daniel, F-91190 Les Ulis (FR); YAM, Vy, F-91300 Massy (FR); CAMMILLERI, Vincenzo Davide, F-75014 Paris (FR); FOSSARD, Frédéric, F-91430 Igny (FR); RENARD, Charles, F-78114 Magny Les Hameaux, (FR)
(74) Mandataire: Pontet Allano & Associes
(86) Numéro de dépôt international: PCT/FR2008/052304
(87) Numéro de publication internationale: WO 2009/081015

(56) Documents cités:
- EP-A- 1 378 934
- US-A- 4 876 210
- US-A- 5 846 320
- US-B1- 6 500 257

## Description

La présente invention concerne un procédé de réalisation par hétéro épitaxie d'une couche de semi-conducteur tel que du germanium sur la surface d'un matériau isolant. Cette croissance s'effectue en au moins une zone choisie et par croissance latérale selon une progression s'effectuant majoritairement dans le plan de cette surface isolante. Elle concerne aussi la réalisation d'une base de fabrication ou « wafer » de circuit intégré homogène ou hétérogène sur germanium, ainsi qu'un système de réalisation de telles bases.

L'invention relève des domaines de la préparation et du traitement des plaques ou supports à base d'un matériau semi-conducteur ou comprenant des semi-conducteurs en couches minces, utilisés en particulier pour la réalisation de circuits intégrés en électronique et microélectronique, ou la fabrication en masse de composants plus basiques voire élémentaires.

Les circuits intégrés ou « puces » comprennent une grande quantité de composants élémentaires à base de semi-conducteurs, comme des transistors, qui sont fabriqués ensemble dans leur configuration complète en travaillant une plaque de base. Ces plaques de base, souvent appelées galettes ou « wafer » en anglais, sont en général des disques comprenant un ou plusieurs semi-conducteurs, en général du silicium cristallisé.

La tendance actuelle de l'industrie microélectronique est de chercher à augmenter la densité d'intégration et la vitesse de commutation des processeurs, en particulier en produisant des dispositifs élémentaires (transistors) de plus en plus petits ou en utilisant de nouveaux semiconducteurs bénéficiant de meilleures performances.

La dimension typique qui va définir les règles de dessin et la densité d'intégration est la distance entre source et drain du transistor à effet de champ métal-oxyde-semiconducteur (MOSFET) élémentaire. La génération actuelle, comme les processeurs « Core 2 » et « Core 2 Duo » de la société Intel, utilise une technologie de l'ordre de 65 nm (nanomètres). Pour la prochaine génération de circuits intégrés, cette distance caractéristique sera de 45 nm. On envisage d'ici 8-10 ans de passer à 22 nm.

Or, la réduction en dimensions du transistor s'accompagne de perturbations dans son fonctionnement qui sont appelés des "effets de canal court". La commande par la tension de grille devient de moins en moins efficace au fur et à mesure que l'on raccourcit le canal. Ces effets de canal court sont très fortement réduits si le transistor est construit dans une couche mince, par exemple d'environ 100 nm, de semiconducteur posée sur un isolant, plutôt que taillé à la surface d'une couche épaisse. Cette architecture permet alors de recouvrer une commande efficace. Pour un transistor classique, c'est à dire tout en silicium, cette architecture peut être réalisée sur base, ou substrat, de type "SOI" (« silicon on insulator »), par exemple obtenu par la technique de collage dite "smartcut", technique développée en France par la Société SOITec.

Par ailleurs, la vitesse de commutation et la dissipation de chaleur sont améliorées en remplaçant le silicium par le germanium, qui possède des propriétés de transport plus favorables. La présence de germanium, dont le paramètre de maille est égal à celui de l'arséniure de gallium, ouvre aussi la porte à l'intégration hétérogène de semiconducteurs de type III-V.

Or l'utilisation de germanium représente un coût nettement plus important que le silicium, de l'ordre de quatre à cinq fois, et comporte des difficultés techniques.

En particulier, pour les mêmes raisons que pour le silicium, il devient intéressant de réaliser de tels transistors sur un isolant par une technique de « GOI » (« Germanium On Insulator »). Or les techniques actuelles de réalisation de tels substrats présentent des inconvénients.

La technologie dite « Smartcut » est particulièrement délicate et coûteuse pour le germanium, et ne permet pas actuellement d'obtenir de très grands diamètres de galettes.

Une technique dite de condensation en cours de développement consiste à déposer un alliage silicium-germanium sur un substrat de type SOI, pour en expurger ensuite le silicium par oxydation à haute température puis par enlèvement de l'oxyde de silicium formé à la surface. Cette technique ne permet pas actuellement une pureté toujours satisfaisante du germanium. Elle utilise de plus une couche de germanium sur toute la surface, même non utilisée. Elle nécessite aussi encore beaucoup de mises au point ainsi que des investissements industriels conséquents pour être employée en production.

Les techniques connues de croissance de germanium sur un substrat de silicium par hétéro épitaxie présentent rapidement un trop grand nombre de défauts dans la structure cristalline du germanium obtenu, ce qui ne permet pas une production industrielle d'une qualité suffisante.

### Etat de la technique

Une méthode de croissance parallèle à la surface de l'isolant est proposée par la publication Yaocheng Liu et al., dans « Applied Physics Letters » vol.84, n°14 p2563. Cette technique consiste à aménager à la surface d'un isolant recouvrant le silicium une sorte de poche fermée formant un réservoir sur l'étendue de la zone à recouvrir. En une extrémité, ce réservoir est en contact avec une partie non recouverte de la surface du substrat de silicium. Cette partie est utilisée comme une zone de germination au cours d'un procédé de croissance par épitaxie en phase liquide, pratiquée à l'intérieur de ce réservoir. En donnant une forme particulière au réservoir aux alentours de la zone de germination, cette technique comprend une réduction des défauts par un étranglement « defect necking technique » qui permet de limiter la propagation des dislocations.

Cette technique nécessite une température importante, qui risque de contaminer le germanium avec du silicium, possiblement jusqu'à des taux de l'ordre de 1%. Elle présente aussi une certaine complexité, et donc un coût et des délais importants pour la mise au point et l'industrialisation.

De plus, la qualité cristalline du germanium obtenu dépend largement de l'efficacité de l'étranglement pour la réduction des défauts, ce qui est une source de complexité et peut se révéler insuffisant en performance ou en répétabilité.

Dans le document EP 1 378 934, pour une croissance de GaN sur un substrat de saphir, les défauts créés lors de la germination sont réduits à un stade ultérieur de la croissance, par plusieurs changements de direction de croissance. Cette méthode nécessite de déposer deux masques superposés et d'épaisseur différente, voire même se recouvrant partiellement l'un l'autre. En outre, pour pouvoir être peut-être appliquée au germanium, cette méthode rendrait nécessaire la réalisation d'au moins une étape supplémentaire préalable d'épitaxie pleine plaque. Une telle étape supplémentaire compliquerait le processus, et rendrait difficile ou interdirait la possibilité de co-intégration de différents types de circuits au même niveau.

De façon similaire, le document US 6,500,257 propose aussi une méthode de croissance avec changements de direction, pour l'obtention de GaN sur un substrat saphir. Cette méthode part d'une première couche de GaN déposée sur le substrat, et dans laquelle est creusée une tranchée. Sur le GaN avec dislocations des parois de cette tranchée est réalisée une croissance latérale de GaN, donc en homo-épitaxie. Cette croissance latérale, associée à de nouveaux changements de directions, est utilisée pour diminuer le taux de dislocations de la couche finale.

Cette méthode présenterait des inconvénients similaires aux précédentes, par exemple dans les difficultés de transposition et les niveaux de performances. Elle nécessite elle aussi des opérations nombreuses et complexes.

Par ailleurs, la publication « Epitaxial growth of Ge on thin SiO2 layer by ultrahigh vacuum chemical vaport deposition » de Halbwax et al. dans le « Journal of Crystal Growth 308 (2007) 26-29 » propose une technologie permettant d'obtenir une croissance de germanium monocristallin sans défaut sur une largeur de l'ordre de 500 nanomètres, à la surface d'une couche mince de silice ou oxyde de silicium (SiO₂).

Ce document propose de réaliser une attaque presque totale de l'épaisseur d'une couche de silice sur un substrat silicium, jusqu'à ce que de très étroites ouvertures se créent dans cette couche laissant apparaître le silicium du substrat. Une croissance de germanium est ensuite réalisée par dépôt chimique en phase gazeux en ultravide (UHV-CVD) ou par épitaxie par jets moléculaires (MBE) sur le silicium apparaissant dans ces ouvertures. Avec des conditions de croissance adaptées, cette croissance se poursuit sur la surface de la couche de silice restante de façon monocristalline dans son épaisseur et le long de la surface d'interface avec la silice.

Toutefois, avec cette technique, la couche de silice recouverte par le germanium est toujours extrêmement mince, de l'ordre de 0,6 nanomètre. Cette épaisseur peut peut-être permettre de réaliser des composants de type photodétecteur, mais est largement insuffisante pour obtenir l'effet isolant recherché pour des applications de type transistor. De plus, les points de croissance du germanium sont créés de façon aléatoire sur la surface de la silice, à travers des ouvertures constituant ainsi des points de connexion électrique non contrôlée entre d'une part la couche de germanium obtenue sur la silice et d'autre part le silicium du substrat.

### Objectifs de l'invention

Un but de l'invention est de pallier les inconvénients de l'art antérieur, et en particulier de permettre un dépôt de germanium de bonne qualité en pureté et du point de vue cristallin, en épaisseur contrôlée sur un support isolant d'une épaisseur choisie, en limitant l'apport en germanium et selon un choix souple de motifs de tailles et de formes variées.

L'invention cherche aussi à fournir un procédé de réalisation de support, et de réalisation de circuits ou composants à partir d'un tel support, ainsi qu'un système mettant en oeuvre ces procédés, de façon simple et robuste et en limitant les modifications à apporter aux installations et procédés industriels existants.

### Exposé de l'invention

Dans ce but, l'invention propose une technique qui permet de disposer à l'échelle du transistor d'une zone de semiconducteur de qualité, par exemple du germanium monocristallin, recouvrant une couche d'un autre matériau par exemple isolant. Sa mise en oeuvre perturbe peu le procédé standard de fabrication du transistor MOSFET et produit du matériau non défectueux à un niveau pouvant être industriellement acceptable pour une production de masse recherchant le zéro défaut.

Cette technique utilise une combinaison d'une sélectivité spatiale, basée sur des gravures localisées dans certaines zones seulement pour définir l'emplacement des zones de germination, combinée avec une gravure uniforme de préférence chimique pour faire apparaître ces zones de germination.

Elle met en oeuvre un procédé pour recouvrir d'un semi-conducteur dit de croissance, différent du substrat, une couche d'un premier matériau portée par un substrat, typiquement de silicium, ce premier matériau étant différent du matériau du substrat et différent du semi-conducteur de croissance. Ce procédé comprend :
- à l'aide d'au moins une opération de gravure spatialement sélective, réalisation sur ledit substrat d'une couche de surface dite composite comprenant
   - au moins ledit premier matériau dans une première région et
   - au moins un deuxième matériau, différent du premier matériau et différent du substrat, dans une deuxième région,
   - lesdites première et deuxième régions étant contiguës en au moins une zone d'interface présentant une différence de niveau entre la surface du matériau dudit substrat dans ladite première région et la surface du matériau dudit substrat dans ladite deuxième région ;
- au moins une opération de gravure chimique, affectant au moins ce premier matériau, jusqu'à découvrir au moins une partie du substrat aux abords de ladite interface, typiquement sur une largeur sub micronique, voire inférieure à 100 nm ;
- croissance dudit semi-conducteur de croissance à partir de ladite partie découverte, dite zone de germination.

Cette technique permet en particulier d'obtenir des zones de germination de dimensions particulièrement faibles, au moins en largeur, tout en choisissant leur position. Cette faible dimension permet de minimiser le nombre des dislocations causées par la différence de paramètre de maille entre le silicium du substrat de germination d'une part, et le semi conducteur de croissance que l'on fait croître sur ce substrat. Ce point est très important car il affecte directement la qualité cristalline du matériau obtenu.

Selon l'invention, ces première et deuxième régions sont réparties de façon à présenter au moins une zone d'interface linéaire délimitant en tout ou partie le pourtour d'une région à recouvrir avec le semi-conducteur de croissance.

L'invention permet aussi de contrôler l'épaisseur d'isolant désirée sous le semi-conducteur de croissance, par exemple 10 nanomètres pour être utilisable dans la réalisation de transistors en « Germanium On Isolant ».

Dans l'art antérieur, par exemple dans le document EP 1 378 934, les défauts créés lors de la germination de GaN sont réduits à un stade ultérieur de la croissance, par un changement de direction de croissance. Cette méthode peut être suffisante pour améliorer le GaN, un matériau qui a une forte tendance à contenir des défauts, aux environs de 10⁸/cm².

Au contraire, l'invention permet de contourner le problème des défauts initiaux de croissance hétérogène, en réalisant directement une zone de germination d'une dimension particulièrement réduite, ce qui engendre beaucoup moins de défauts voire aucun.

Dans le cas du germanium, les spécifications à atteindre sont beaucoup plus sévères que pour le GaN. En effet, les qualités actuellement obtenues dans un contexte de croissance par hétéroépitaxie présentent des concentrations en dislocations de l'ordre de 10⁵/cm², soit environ mille fois moins que pour le GaN.

Le procédé selon l'invention permet de créer dans des positions choisies des germes de très faible taille, pouvant descendre jusqu'à environ dix nanomètres. Or un matériau obtenu par hétéroépitaxie (c'est à dire par croissance sur un matériau différent) avec une différence de paramètres de maille présente une quantité de défauts causés par cette différence qui est beaucoup plus faible voire inexistante lorsque cette hétéroépitaxie est basée sur une surface ayant au moins une dimension très faible.

Pour obtenir cette amélioration nette, cette dimension « latérale » de germe doit être inférieure ou égale à une valeur de seuil, pouvant varier selon les conditions et les matériaux entre 20 nm (valeur théorique pour le germanium) et 100 nm (valeur expérimentale obtenue pour un autre couple de matériaux présentant la même différence de paramètre que le couple germanium et le silicium).

Ainsi, en positionnant sélectivement des germes d'une taille inférieure à cette valeur de seuil, l'invention utilise cette propriété pour obtenir, par dessus le premier matériau et dans les zones choisies, un matériau de croissance de meilleure qualité que les méthodes connues. Les premiers résultats montrent déjà que l'invention permet ainsi d'obtenir un taux de dislocations descendant en dessous de la valeur de 10⁵/cm² (cent mille par centimètre carré), pour une hétéroépitaxie de germanium sur silicium.

Dans le procédé selon l'invention, cette zone de germination étroite est obtenue en contournant un verrou technologique propre aux technologies de lithographie optique : la résolution minimale atteignable. Grâce à l'invention, ce résultat est obtenu sans avoir recours à une lithographie électronique, qui constituerait un effort technologique et donc un coût très important sur de nombreux plans, en particulier pour une production à une échelle industrielle.

De préférence, la zone à recouvrir est choisie de façon à ce qu'au moins une zone de germination présente une direction longitudinale perpendiculaire à la direction cristallographique <110> du substrat.

Dans les modes de réalisation décrits ici, le semi-conducteur de croissance est du germanium. Il pourrait cependant s'agir d'autres semi-conducteurs de type III-V sans sortir du cadre de l'invention, par exemple de l'arséniure de gallium (GaAs), ou du phosphure d'indium (InP).

La technique « auto alignée » décrite ici permet d'obtenir directement des zones de germination d'une largeur inférieure à 100 nm pour la plupart des matériaux à faire croître. Grace à l'invention, cette largeur peut descendre jusqu'à moins de 30 nm, voire 20 ou 10 nm pour certains matériaux tels que le germanium, fournissant ainsi une bonne qualité cristalline pour le germanium ou le matériau de croissance ainsi obtenu. Jusqu'à présent au contraire, pour réaliser une zone de germination faisant apparaître du silicium du substrat au sein d'une couche d'un autre matériau, les technologies classiques de lithographie optique par contact ne permettent pas d'obtenir des dimensions inférieures à quelques centaines de nanomètres, avec un positionnement choisi et précis et avec une bonne répétabilité. Des limites similaires existent en lithographie optique par projection, qui ne permettent pas de descendre au dessous de 60 nm.

De façon avantageuse, l'étape de gravure de la zone d'interface est choisie pour graver le premier matériau sélectivement par rapport au deuxième matériau, ce qui permet un contrôle plus facile de l'apparition de la zone de germination.

En plus des avantages de la faible largeur de la zone de germination, le positionnement de la zone de germination permet aussi d'induire une ou plusieurs rotations de la direction de croissance du germanium entre sa germination sur le silicium et la partie exploitable recouvrant la surface isolante, ce qui améliore aussi la qualité cristalline en diminuant encore le nombre de dislocations pouvant subsister.

Dans la présente description, le « premier matériau » recouvrant la « première région » sera souvent décrit comme un matériau électriquement isolant, du fait des débouchés directs pour la réalisation de substrat de type GeOI. Il doit cependant être compris que l'invention s'applique aussi à d'autres matériaux qui seraient intéressants pour d'autres raisons.

Dans les modes de réalisation ici décrits, la formation du premier matériau comprend une transformation superficielle du silicium du substrat en un matériau isolant comprenant du SiO₂, et la formation du deuxième matériau comprend un dépôt de Si₃N₄. D'autres combinaisons peuvent toutefois être envisagées parmi les matériaux connus de l'homme du métier et permettant d'obtenir cette couche composite.

Dans un premier mode de réalisation préféré, l'invention propose un procédé comprenant les étapes suivantes :
- formation d'un masque de protection : formation d'une couche de deuxième matériau (typiquement du Si₃N₄) selon un motif partiel, dit masque de protection, choisi pour déterminer la position d'au moins une zone de germination ;
- formation d'une couche de premier matériau (typiquement l'isolant SiO₂) à l'intérieur de l'espace libre dudit masque de protection, la surface du substrat à l'intérieur dudit espace libre se situant plus bas que la surface du substrat dans l'espace recouvert par ledit masque de protection ;
- à l'aide d'au moins une opération de gravure chimique, par exemple sélective d'un type présentant une cinématique d'action plus rapide sur ledit premier matériau (l'isolant), diminution de l'épaisseur dudit premier matériau jusqu'à découvrir au moins une partie du silicium du substrat, formant ainsi une zone de germination sur le bord du masque de protection.

Ce masque de protection permet en particulier de limiter la zone de germination à ce qui est utile et efficace. De plus, il peut former un léger surplomb qui concoure à guider la croissance du germanium pour l'amener sensiblement parallèle à la surface du support isolant au fond de la zone à recouvrir. La présence de ce surplomb peut aussi réaliser un étranglement susceptible de réduire les défauts cristallins, par exemple venant de la différence de paramètres de maille existant entre le matériau (Si) de la zone de germination et celui (Ge par exemple) que l'on fait croître.

Plus particulièrement, l'étape de formation de l'isolant au fond de la zone gravée comprend une transformation superficielle du Silicium de la zone gravée en un matériau isolant formant le support à recouvrir, par exemple en SiO₂.

Le masque de protection peut alors être fait de tout matériau capable de protéger le silicium du substrat lors de la transformation superficielle dans la zone gravée, et donc dans cet exemple de protéger le silicium de l'oxydation.

Dans ce mode de réalisation préféré, l'invention est très intéressante par sa capacité à être mise en oeuvre simplement dans les installations industrielles connues ou existantes comprenant des installations de fabrication par oxydation, comme celles utilisées pour le procédé « LOCOS ». Le procédé selon l'invention comprend alors les étapes suivantes :
- utilisation d'un procédé du type « LOCal Oxydation of Silicon » pour réaliser au moins une zone de silicium à recouvrir de germanium au sein d'un masque définissant un motif sur un substrat de silicium et transformation de la surface de ladite zone en une couche de SiO₂, ;
- attaque ou gravure isotrope de ladite couche de SiO₂ en au moins une région incluant un bord de ladite zone à recouvrir, jusqu'à découvrir une zone de silicium derrière ladite couche de SiO₂ ;
- utilisation de la zone découverte comme zone de germination pour réaliser une croissance épitaxiale de germanium le long de la surface du SiO₂ subsistant à la surface de ladite zone à recouvrir.

### Autres modes de réalisation

D'autres modes de réalisation peuvent être combinés avec le mode préféré ou entre eux, par exemple dans différentes régions d'une même tranche ou « wafer ».

Dans un deuxième mode de réalisation, le procédé selon l'invention utilise un substrat portant une couche de premier matériau (ici l'isolant SiO₂) sur laquelle est déposé le masque de protection (ici le Si₃N₄). Cette couche de premier matériau (SiO₂) peut être complète sur le substrat, mais aussi être interrompue dans certaines zones.

Le procédé selon l'invention peut en particulier utiliser directement un substrat déjà modifié selon le procédé dit STI (Shallow trench isolation), sur lequel est alors déposée la couche formant le masque de protection (ici le Si₃N₄).

Dans ce deuxième mode de réalisation, le procédé selon l'invention peut alors utiliser encore plus simplement le procédé LOCOS standard, voire sans modification, puisque celui-ci qui comprend normalement une couche d'oxyde avant masquage.

L'invention peut alors s'appliquer à un substrat déjà modifié selon le procédé STI, et donc être intégrée de façon assez simple dans une production utilisant ce procédé, par exemple une production de composants à base de transistors MOS-FET.

Le masque de nitrure peut être enlevé ultérieurement si les procédés technologiques ultérieurs excluent la présence de nitrure de silicium.

Ce mode de réalisation permet aussi, en enlevant le masque après découverte de la zone de germination mais avant la croissance du germanium, de faire croître le germanium sur une surface plus large, aussi bien la zone ouverte dans le masque de protection que la zone recouverte par ce même masque. Il est ainsi possible d'obtenir une zone plus étendue de « Germanium On Insulator », ou positionnée différemment.

Par exemple dans des procédés de réalisation des transistors MOSFET, l'invention permet aussi de faire croître le germanium sur la zone d'intérêt avec une modification limitée des procédés existants.

Le contrôle de la largeur de la zone de germination est obtenu en particulier par un contrôle :
- d'une part de la différence de niveaux des surfaces de silicium sous les premier et deuxième matériaux, et
- d'autre part de la cinématique d'action de l'opération de gravure chimiquement sélective sur l'un ou l'autre desdits premier et deuxième matériaux, qui permet de découvrir la zone de germination.

Ce contrôle de la largeur de la zone de germination réalise alors un contrôle de la qualité cristalline du germanium obtenu.

En réalisant une telle couche de germanium sur isolant, l'invention propose alors d'utiliser le procédé pour réaliser une base (ou « wafer ») pour une fabrication de circuits intégrés ou de composants à base de Germanium.

Selon l'invention, une telle base de fabrication peut aussi être réalisée en créant localement une ou plusieurs zones de germination, pour ne recouvrir de germanium que certaines zones choisies sur un substrat en silicium.

Il est ainsi possible d'intégrer des composants ou sous ensembles de technologies différentes, à base de germanium ou de silicium voire d'autres semi-conducteurs (GaAs, etc.), dans un support hétérogène, par exemple pour réaliser des circuits hétérogènes.

En particulier, il est ainsi possible de combiner des composants performants en vitesse à base de germanium sur isolant, avec des composants sur substrat de silicium pleine masse qui permet une dissipation thermique plus efficace. Un exemple serait un circuit combinant une porte logique, comme une porte AND, avec un ou plusieurs transistors de puissance comme un transistor bipolaire. (technologie BiCMOS)

Il y a de nombreux avantages à une telle technique. Un avantage important est le coût limité, puisque l'on peut partir de tranches de silicium standard, disponibles en 20 cm ou 30 cm de diamètre ou plus, dans le futur. Le coût additionnel vient surtout de l'étape d'épitaxie par pyrolyse d'hydrure, qui est présente en standard dans les fonderies actuelles.

De plus, l'aspect localisé de cette technique laisse la possibilité de mélanger facilement des dispositifs sur silicium et germanium dans le même circuit intégré. Enfin, et c'est un point important, il s'avère que l'épitaxie latérale de germanium sur silice ne génère pas de dislocations.

Une application immédiate est la fabrication de transistors à effet de champ de type P dit "complètement déplété" ou « complètement déserté » en germanium (Ge FD-MOSFET pour "germanium fully depleted metal-oxide-semiconductor field effect transistor").

De plus, le germanium constitue aussi un support adapté à la croissance épitaxiale d'arséniure de gallium (GaAs), dont il partage les paramètres de maille. Or, bien que non explicitement mentionné par l'ITRS (stratégie internationale de développement : « International Technology Roadmap for Semiconductors ») l'arséniure de gallium devrait être utilisé dans les prochaines générations de MOSFET (noeud 22nm et au dessous) comme canal de type N. Le procédé permet donc d'accéder au FD-MOSFET de type N très haute mobilité, soit en faisant croître de l'arséniure de gallium à la place du germanium ici décrit, soit en le faisant croître sur le germanium ainsi obtenu. D'autres applications nécessitant l'intégration hétérogène de semiconducteurs III-V sont donc aussi ouvertes, en optoélectronique par exemple.

D'autres particularités et avantages de l'invention ressortiront de la description détaillée d'un mode de mise en oeuvre nullement limitatif, et des dessins annexés sur lesquels :
- les FIGURE 1 et FIGURE 2 illustrent schématiquement différents stades de déroulement du procédé selon l'invention, dans le premier mode de réalisation ;
- la FIGURE 3 illustre schématiquement différents stades de déroulement du procédé selon l'invention, dans le deuxième mode de réalisation ;
- la FIGURE 4 illustre schématiquement certains stades de déroulement du procédé selon l'invention, dans une variante du deuxième mode de réalisation ;
- la FIGURE 5 illustre schématiquement les différents stades de déroulement du procédé selon l'invention, dans le premier mode de réalisation appliqué à un substrat déjà préféré selon le procédé «STI»;
- la FIGURE 6 illustre un exemple d'utilisation du procédé selon l'invention pour la fabrication de circuits intégrés hybrides.

Il s'agit d'un procédé simple permettant de faire croître du germanium monocristallin sans défauts sur une zone limitée d'oxyde de silicium obtenue par oxydation thermique, et qui formera l'isolant à recouvrir par le germanium.

La croissance de germanium par pyrolyse du germane (GeH₄) sur l'oxyde est initiée à partir d'une bande étroite de silicium située en périphérie de la zone oxydée et se poursuit par mouillage de la surface d'oxyde selon une cinétique déterminée.

Cette bande de silicium qui sert de germe à la croissance cristalline présente avantageusement une largeur faible afin de limiter la propagation de défauts au dessus de la couche d'oxyde de silicium. Dans ce procédé, la largeur de la zone de germination est typiquement égale à 20-30 nanomètres, voire 10-50 nanomètres. Cette très faible dimension est obtenue avec un effort technologique réduit, ce qui contribue à l'originalité de l'invention.

### Description détaillée du mode de réalisation préféré

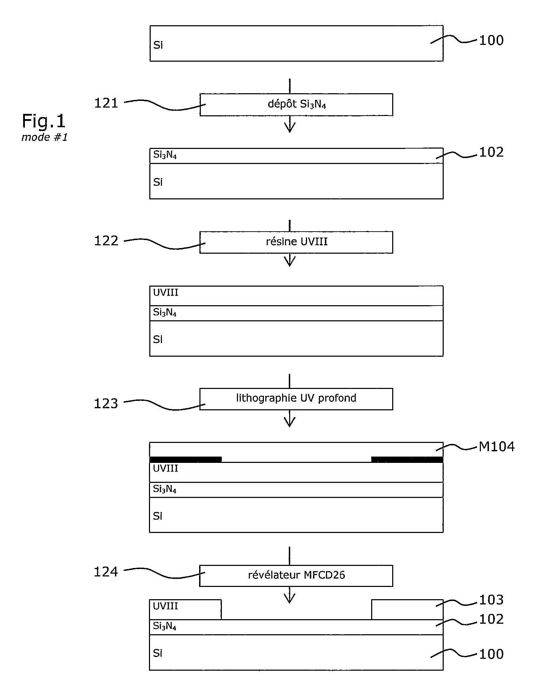

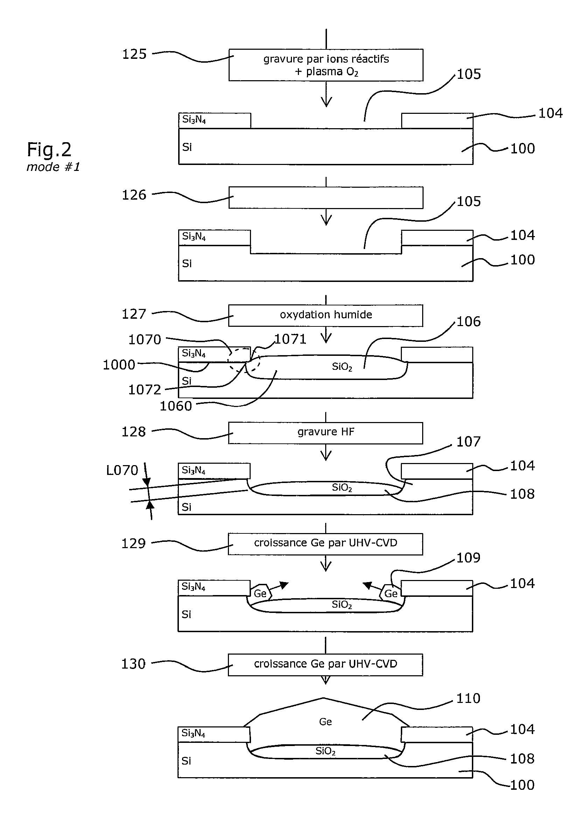

Les FIGURE 1 et FIGURE 2 illustrent l'invention dans son mode de réalisation préféré.

Pour choisir les zones de germination et de croissance, ici directement sur la surface d'une tranche ou « wafer » de silicium, on réalise un masque en nitrure de silicium par dépôt, lithographie et gravure, qui définit les zones que l'on souhaite oxyder sur le silicium, selon les étapes suivantes :
- en une étape 121, on forme par dépôt chimique en phase gazeuse assistée par plasma une couche 102, ici appelée couche de protection, de nitrure de silicium Si₃N₄ sur le substrat 100 de Silicium.
- en une étape 122, on dépose une couche de résine de type UVIII sur la couche 102 de nitrure.
- en une étape 123, on impressionne sélectivement les zones à recouvrir par un rayonnement en UV profond, par exemple par lithographie utilisant un masque amovible de lithographie M104, typiquement en quartz avec surface chromée dans les zones à opacifier, appliqué sur la couche de résine UVIII.
- en une étape 124, par application d'un révélateur tel que MFCD26, les zones insolées de la couche de résine sont retirées pour découvrir le nitrure de silicium de la couche de protection 102. La résine subsistante forme ainsi un masque de gravure 103 laissant apparaître au moins la zone à recouvrir ultérieurement de Germanium.
- en une étape 125, on grave par ions réactifs la couche de protection 102 dans ses zones découvertes par le masque de gravure 103, jusqu'à découvrir le silicium 100 du substrat dans la zone 105 à recouvrir de germanium. La couche de protection 102 est ainsi transformée en un masque 104, ici appelé masque de protection.

De façon préférentielle mais non obligatoire, on réalise une gravure 126 de la surface apparente du silicium 100 dans cette zone 105 à recouvrir, pour former une zone creusée dans cette couche de silicium. Cette gravure du silicium peut se faire séparément et après la gravure 125 du masque 104. Elle peut aussi se faire dans la continuité de celle-ci 125, dès lors que le silicium y est sensible lui aussi.

L'ensemble de la tranche est ensuite oxydée en une étape 127, par exemple sous pression partielle de vapeur d'eau à une température de 1050°C pendant quelques minutes. Cette oxydation produit des zones oxydées 106 d'environ 100nm d'épaisseur, localisées dans les fenêtres précédemment ouvertes dans la couche de nitrure. A travers le masque de protection 104, on réalise ainsi une transformation superficielle en SiO₂ du silicium de la zone 105 exposée, formant des zones en creux dans la surface du silicium subsistant.

A l'issue de cette étape 127, le nitrure 104 et l'oxyde 106 forment deux régions d'une couche composite et sont contiguës dans la zone d'interface 1070 déterminée par la différence de niveau entre la surface initiale 1000 du substrat 100 et la surface 1060 du substrat sous la couche d'oxyde 106 formée au fond de la zone creusée 105. Dans cet exemple, cette zone d'interface 1070 inclût la séparation 1071 entre le nitrure 104 et l'oxyde106, ainsi qu'une arête 1072 formée par la différence de niveau à la surface 1000 du substrat 100.

Une étape 128 comprend alors une attaque ou gravure isotrope sélective du SiO₂ appliquée à l'ensemble de la tranche. Cette attaque ou gravure est dosée jusqu'à découvrir le silicium 100 derrière le SiO₂, mais en s'arrêtant avant la disparition complète de l'oxyde de silicium 106 du fond de la zone creusée 105. Le silicium est découvert dans une zone située derrière l'interface entre SiO₂ et masque de Si₃N₄ avant disparition complète du SiO₂ du fond de la zone 105, en particulier du fait de la moindre épaisseur de SiO₂ à cet endroit.

En particulier, cette étape 128 peut se faire en dissolvant une partie de la couche d'oxyde 106 dans une solution à base d'acide fluorhydrique, ce qui libère sous le masque 104 de nitrure une étroite bande 107 de silicium qui va servir de zone de germination. Sa position sur les côtés de la zone creusée 105 en fait un accident de forme dépassant de la surface de l'isolant 108 subsistant au fond de la zone creusée 105.

La solution à base d'acide fluorhydrique (HF) présente une sélectivité d'attaque plus marquée sur l'oxyde de silicium que sur le nitrure, ce qui permet de faciliter le réglage de cette étape. Il serait cependant possible d'utiliser une autre solution ne présentant pas la même sélectivité. En effet, l'attaque chimique 127 se fait de façon isotrope et progresse donc dans une direction perpendiculaire à la surface extérieure de la zone attaquée. Dans la zone d'interface 1070, cette direction d'attaque n'est donc pas verticale mais oblique voire horizontale. Selon cette direction, du fait de la dénivellation entre les surfaces 1000 et 1060 du silicium, l'épaisseur d'oxyde 106 est moindre que selon la verticale au fond de la zone gravée 105. L'attaque progressant selon cette direction atteint donc la paroi verticale 107 du silicium 100, et son arête 1072, avant que les couches de nitrure 104 (en cas de faible sélectivité) et d'oxyde de silicium 106 ne disparaissent complètement dans les autres zones.

Plus particulièrement, on notera que la zone de germination 107 obtenue se situe à cheval sur l'emplacement (on peut dire qu'elle l'entoure) où était située la séparation 1071 entre le SiO₂ et le Si₃N₄ avant cette étape 128. Grâce à la différence de niveau initiale, cette attaque ou gravure 128 a permis d'attaquer une seule séparation 1071, et de creuser à partir de cette séparation 1071 et ses alentours pour ne découvrir qu'une très étroite zone 107 du substrat, par exemple une zone d'une largeur L107 de 20 nm à 30 nm, voire de 20 à 50 nm. Ce point constitue une différence par rapport à l'art antérieur du document EP 1 378 934, dans lequel l'attaque s'applique au matériau présent sur toute la largeur située entre des parois de masque délimitant dès l'origine une zone à découvrir.

La largeur L107 de cette zone 107 peut être réglée en ajustant la cinématique de l'étape 128 de gravure chimique, et l'épaisseur de SiO₂ 108 restant peut être ajustée en réglant l'épaisseur de la couche de SiO₂ préalablement formée 127.

La croissance de germanium peut alors être effectuée, typiquement par pyrolyse de germane ou hydrure GeH4 selon un procédé de type CVD (« Chemical Vapor Deposition »), et en particulier le procédé UHV-CVD, par exemple selon les techniques de croissance de germanium sur silice exposées dans la publication Halbwax et al.. La croissance du cristal de germanium 109 démarre sur la zone de germination 107 entourant la couche d'oxyde 108 subsistant.

A partir de la zone 107 de silicium découverte, la croissance de germanium monocristallin 109 se propage latéralement sur la surface de la couche d'oxyde 108. On laisse la croissance se poursuivre jusqu'au recouvrement complet de la couche oxydée 108 au sein de la zone creusée 105, formant alors une couche 110 de germanium au dessus de la couche 108 d'oxyde isolant.

Le recouvrement de bandes de silice de 500 nm de large a été testé. L'observation par microscopie électronique à balayage montre des cristaux facettés homogènes sans défauts apparents. Dans des conditions de pression de germane bien choisies, il n'y a pas de croissance sur le masque de nitrure. Pour observer les défauts structuraux (dislocations, fautes d'empilement), il faut utiliser la microscopie électronique en transmission. Les premiers résultats indiquent que l'interface entre le germanium et l'oxyde contient peu ou pas de dislocations.

La croissance de germanium dans une fenêtre 105 ouverte dans le masque de nitrure 104 est particulièrement favorable et de bonne qualité lorsque la zone de germination 107 est allongée selon une direction perpendiculaire à la direction cristallographique <110>. Ainsi, la zone 105 à recouvrir sera choisie de préférence selon une forme dont tous les côtés sont perpendiculaires à cette direction <110> ou à l'une des directions équivalentes (c.à.d. <-110>, <-1-10>, et <1-10>). Dans une telle fenêtre, par exemple rectangulaire ou carrée dont un côté est perpendiculaire à la direction <110>, la croissance 129, 130 de germanium conduit à la formation de facettes orientées selon les axes cristallographiques <113>. Le cristal obtenu 110 a donc une allure en "hutte" avec un toit à deux pentes inclinées à 25°.

S'il en est besoin, il est possible de remédier à cette forme en toit par polissage mécano-chimique ou « CMP », qui est une méthode déjà très largement utilisée en standard dans l'industrie de la microélectronique. Il convient de remarquer que l'étape de CMP n'est pas particulièrement contraignante et est acceptée sans restriction dans les filières industrielles concernées.

En particulier, tout ou partie des étapes allant jusqu'à et y compris la création 127 d'une couche d'isolant 106 peuvent être réalisées selon les techniques employées dans le procédé global LOCOS (« LOCal Oxydation of Silicon ») utilisé pour la filière de transistors MOSFET, ce qui rend l'invention particulièrement simple à implémenter dans les installations actuelles, d'autant plus que le procédé LOCOS est compatible avec le procédé STI, et peut utiliser directement des produits obtenus par lui.

Dans le procédé selon l'invention, il est clair que la zone 105 à recouvrir d'isolant puis de germanium peut ainsi être facilement positionnée sur la surface du substrat 100 de silicium en autant de formes et d'emplacements que de besoin par ce procédé.

En dehors de la lithographie pour la création du masque de gravure correspondant à des technologies bien rôdées, l'ensemble des autres opérations ici décrites ne comprend que des opérations globales s'effectuant sur l'ensemble de la tranche et donc d'un coût technologique limité quels que soient les motifs à recouvrir ou les dimensions de la tranche.

### Description d'autres modes de réalisation

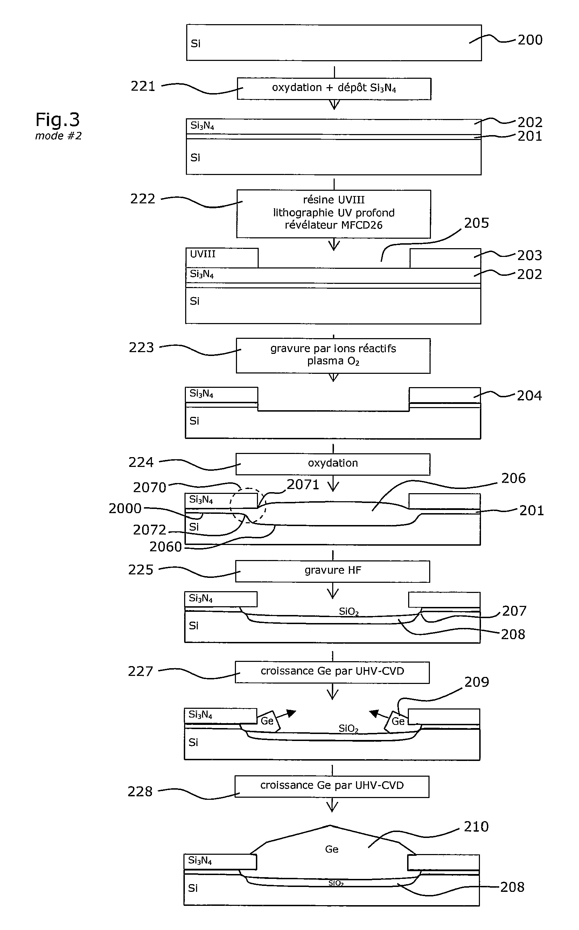

La FIGURE 3 illustre le deuxième mode de réalisation, qui comprend les étapes suivantes :
- formation 221 d'une couche 201 de premier matériau comprenant du SiO₂ sur la surface du silicium du substrat 200 ;
- formation 221 d'une couche dite de protection 202 en deuxième matériau sur la couche 201 de premier matériau ;
- gravure 222 sélective spatialement de la couche de protection 202 pour réaliser un masque de protection 204 laissant apparaître le silicium 200 dans au moins une zone 205 à recouvrir de germanium ;
- optionnellement, gravure 223 de la surface apparente du silicium 100 dans ladite zone à recouvrir 205 pour former une zone creusée ;
- transformation superficielle 224 du silicium de la surface de ladite zone à recouvrir 205 en une couche 206 de premier matériau comprenant du SiO₂ par une oxydation, sèche ou humide.

A l'issue de cette étape 224, le nitrure 204 et l'oxyde 206 forment deux régions d'une couche composite de surface et sont contiguës dans la zone d'interface 2070 déterminée par la différence de niveau entre la surface initiale 2000 du substrat de silicium 200 et la surface 2060 du substrat sous la couche d'oxyde 206 formée au fond de la zone creusée 205.
- attaque 225 chimique, typiquement une gravure isotrope chimiquement sélective, par exemple par acide fluorhydrique, du premier matériau (SiO₂) 206 d'au moins une zone d'interface entre le masque de protection 204 et ce premier matériau 206 de ladite zone à recouvrir 205, jusqu'à découvrir une zone 207 de silicium derrière ledit premier matériau 206, entourant l'emplacement de l'arête 2072 du substrat et l'emplacement de l'interface initiale 2071 entre le masque de protection 204 et le premier matériau ainsi que l'emplacement de l'arête 2072 ;
- germination et croissance épitaxiale 227, 228, de germanium 209 pour former une couche 210 de germanium à partir de ladite zone de silicium 207 découverte.

De même que pour le premier mode de réalisation, la zone de germination 207 est alors utilisée pour réaliser une germination 227 de germanium 209. La croissance est alors poursuivie 228 jusqu'à recouvrir de germanium 210 la couche d'oxyde 208 (le premier matériau) subsistant.

Ce deuxième mode de réalisation est lui aussi compatible avec les procédés LOCOS avec encore moins de modifications voire aucune, puisque le procédé LOCOS comprend de façon classique la formation d'une couche d'oxyde 201 sur le substrat 200 avant masquage par une couche de nitrure 202.

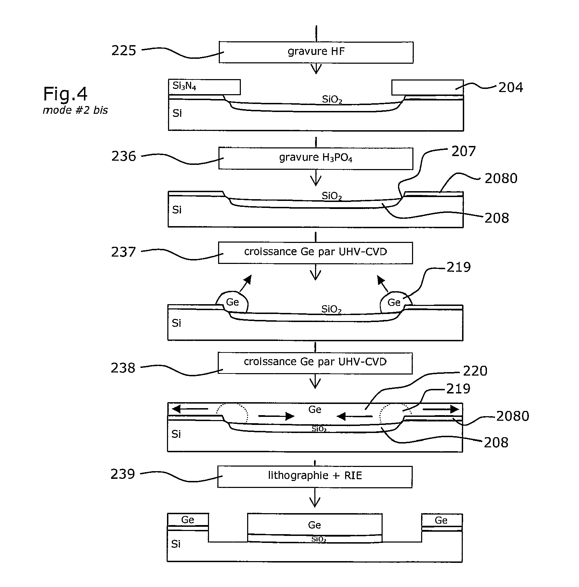

En FIGURE 4 est illustrée une variante optionnelle de ce deuxième mode de réalisation, qui comprend alors en outre les étapes suivantes :
- ultérieurement à la gravure sélective 225 de diminution du premier matériau 206, on réalise une ablation 236 du masque de protection 204 en deuxième matériau par au moins une opération de gravure isotrope chimiquement sélective sur ce deuxième matériau, par exemple par H₃PO₄ ;
- après germination 237, formation 238 d'une couche de germanium 220, par croissance latérale à partir des germes de germanium 219 : à la fois sur le premier matériau 208 de la zone 205 et à la fois sur la surface de la couche de premier matériau 2080 dans la région découverte par ladite ablation 236 du masque de protection 204.

Ultérieurement, pour ce mode de réalisation mais aussi pour les autres modes de réalisation de l'invention, les zones de germination 207 peuvent être éliminées par une gravure localisée 239.

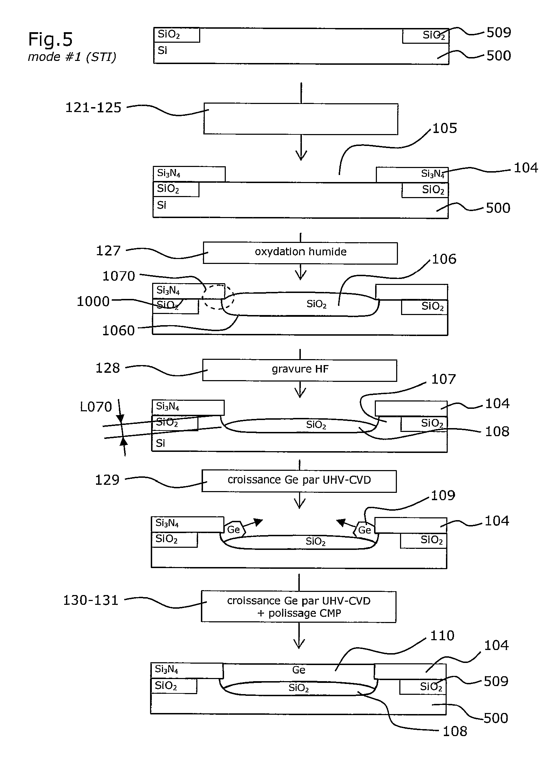

En FIGURE 5 est illustrée l'application du mode de réalisation des FIGURE 1 et FIGURE 2 à un substrat déjà préparé selon le procédé STI, après réalisation des tranchées 509 de silice sur le silicium 500 du substrat initial.

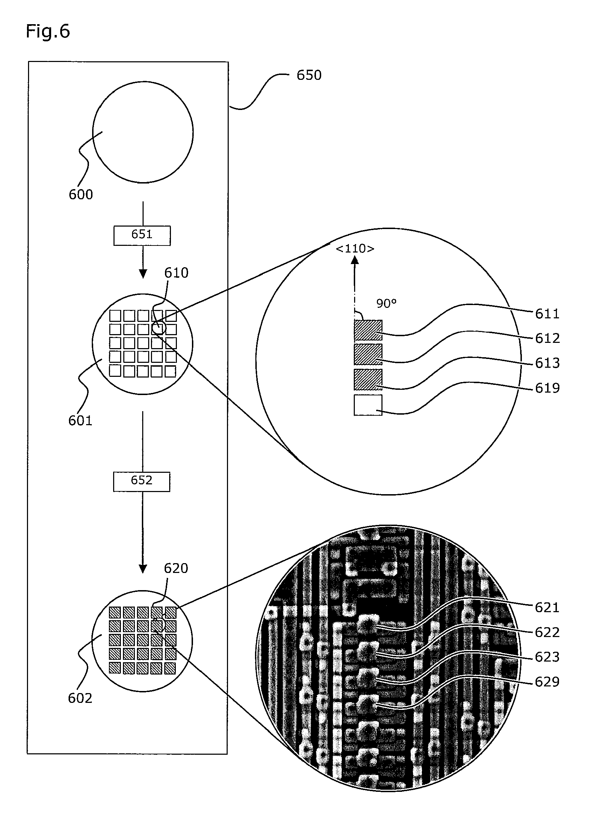

La FIGURE 6 illustre l'utilisation d'un procédé selon l'invention, au sein d'un processus 650 de fabrication de circuits intégrés hybrides, par exemple silicium/germanium.

Une tranche ou « wafer » 600 de silicium monocristallin est utilisée 650 comme base pour réaliser une pluralité de circuits intégrés 620 hybrides.

Dans une partie 651 du processus de fabrication, le procédé selon l'invention est utilisé pour recouvrir de silice puis de germanium monocristallin des zones 611, 612 et 613 précises positionnées au sein de chacun des emplacements 610 du wafer 601, fournissant des zones localisées de GeOI.

Ces sont zones 611, 612 et 613 déterminées pour correspondre à l'endroit où seront réalisés, dans la suite 652 du processus, certains composants que l'on souhaite baser sur du germanium et non sur du silicium, par exemple des transistors rapides 621, 622 et 623.

Ainsi, seules les zones utiles 611, 612 et 613 seront recouvertes de germanium. Les zones 619 destinées à la réalisation de composants à base de silicium, par exemple des transistors 629, n'ont pas besoin d'être recouvertes de germanium par le procédé selon l'invention.

L'invention permet ainsi la réalisation de circuits intégrés hybrides avec de bonnes performances d'intégration, en utilisant peu de germanium et avec un effort technologique et industriel limité par rapport aux installations industrielles existantes dans la filière silicium.

## Revendications

1. Procédé pour recouvrir, à l'aide d'un semi-conducteur (110, 210) dit de croissance, différent du silicium, une couche d'un premier matériau (108, 208) portée par un substrat (100, 200) de silicium, ledit premier matériau étant différent du matériau du substrat et différent du semi-conducteur de croissance, ledit procédé comprenant :
- à l'aide d'au moins une opération de gravure spatialement sélective, réalisation sur ledit substrat d'une couche de surface dite composite comprenant
. au moins ledit premier matériau (106, 206) dans une première région et
. au moins un deuxième matériau (104, 204), différent du premier matériau et différent du matériau du substrat, dans une deuxième région,
. lesdites première et deuxième régions étant contiguës (1071) en au moins une zone d'interface (1070, 2070) présentant une différence de niveau entre la surface (1060, 2060) du matériau dudit substrat (100, 200) dans ladite première région et la surface (1000, 2000) du matériau dudit substrat dans ladite deuxième région ;
- au moins une opération de gravure chimique (128, 225) dudit premier matériau (108, 208) jusqu'à découvrir au moins une partie (107, 207) du substrat aux abords de ladite interface ;
- croissance (129, 130) dudit semi-conducteur de croissance (109, 110) à partir de la partie ainsi découverte (107), dite zone de germination.

2. Procédé selon la revendication 1, **caractérisé en ce que** la zone de germination (107) présente au moins une dimension (L070) transversale d'une valeur inférieure à cent nanomètres.

3. Procédé selon l'une des revendications précédentes, **caractérisé en ce que** les deux régions (104, 106) sont réparties de façon à présenter au moins une zone d'interface (1070) linéaire délimitant en tout ou partie le pourtour d'une région (105) à recouvrir de semi-conducteur de croissance.

4. Procédé selon l'une quelconque des revendications précédentes, **caractérisé en ce qu'**une zone à recouvrir (105, 205) est choisie de façon à ce qu'au moins une zone de germination (107, 207) présente une direction longitudinale perpendiculaire à la direction cristallographique <110> du substrat.

5. Procédé selon l'une quelconque des revendications précédentes, **caractérisé en ce que** l'étape (128, 225) de gravure de la zone d'interface (1070, 2070) est choisie pour graver le premier matériau (106, 206) sélectivement par rapport au deuxième matériau (104, 204).

6. Procédé selon l'une quelconque des revendications précédentes, **caractérisé en ce qu'**il comprend les étapes suivantes :
- formation (122 - 125, 222 - 223) d'une couche de deuxième matériau selon un motif partiel (104, 204), dit masque de protection, choisi pour déterminer la position d'au moins une zone de germination ;
- formation (127, 224) d'une couche (106, 206) de premier matériau à l'intérieur de l'espace libre (105, 205) dudit masque de protection, de façon à ce que la surface (1060, 2060) du substrat à l'intérieur dudit espace libre se situe plus bas que la surface (1000, 2000) du substrat dans la région recouverte par ledit masque de protection ;
- gravure (128, 225) du premier matériau (106, 206) de la zone d'interface (1070, 2070) jusqu'à découvrir la surface sous-jacente du substrat dans au moins une zone localisée formant ainsi une zone de germination (107, 207) au bord dudit masque de protection (104, 204).

7. Procédé selon l'une quelconque des revendications précédentes, **caractérisé en ce que** le substrat (100, 200, 500) est du silicium.

8. Procédé selon l'une quelconque des revendications précédentes, **caractérisé en ce que** le semi-conducteur (109, 110, 209, 210) de croissance est du germanium, ou de l'arséniure de gallium, ou du phosphure d'indium.

9. Procédé selon l'une des revendications 7 ou 8, **caractérisé en ce que** la formation du premier matériau (108, 208) comprend une transformation (127, 224) de la surface d'un substrat (100, 200) de silicium, dans au moins une région (105, 205), en un matériau isolant comprenant du SiO₂.

10. Procédé selon l'une quelconque des revendications précédentes, **caractérisé en ce que** la formation du deuxième matériau (102, 202) comprend un dépôt (121, 221) de Si₃N₄.

11. Procédé selon l'une quelconque des revendications précédentes, **caractérisé en ce qu'**il comprend les étapes suivantes :
- formation (121) d'une couche dite de protection (102) en deuxième matériau sur un substrat (100) de silicium;
- gravure (122 à 125) sélective de la couche de protection (102) pour réaliser un masque de protection (104) laissant apparaître le silicium (100) dans au moins une zone (105) destinée à être recouverte par le semi-conducteur de croissance (106) ;
- transformation superficielle (127) du silicium de la surface de ladite zone à recouvrir (105) en une couche (106) de premier matériau comprenant du SiO₂ ;
- attaque ou gravure isotrope (128) du SiO₂ (106) d'au moins une zone d'interface entre le masque de protection (104) et le premier matériau (106) de ladite zone à recouvrir (105), jusqu'à découvrir une zone (107) de silicium derrière ledit premier matériau ;
- germination et croissance épitaxiale (129, 130) d'une couche (110) de semi-conducteur de croissance à partir de la zone de silicium (107) découverte.

12. Procédé selon l'une quelconque des revendications 1 à 11, **caractérisé en ce qu'**il comprend les étapes suivantes :
- formation (221) d'une couche (201) de premier matériau comprenant du SiO₂ sur la surface d'un substrat de silicium (200) ;
- formation (221) d'une couche dite de protection (202) en deuxième matériau sur la couche (201) de premier matériau ;
- gravure (222) spatialement sélective de la couche de protection (202) pour réaliser un masque de protection (204) laissant apparaître le silicium du substrat (200) dans au moins une zone (205) destinée à être recouverte par le semi-conducteur de croissance ;
- transformation superficielle (224) du silicium de la surface de ladite zone à recouvrir (205) en une couche (206) de premier matériau comprenant du SiO₂ ;
- attaque ou gravure (128) du SiO₂ (206) d'au moins une zone d'interface entre le masque de protection (204) et le premier matériau (206) de ladite zone à recouvrir (205), jusqu'à découvrir une zone (207) de silicium derrière ledit premier matériau (206) ;
- germination et croissance épitaxiale (227, 228) d'une couche (210) de semi-conducteur de croissance à partir de ladite zone de silicium (207) découverte.

13. Procédé selon la revendication 12, **caractérisé en ce qu'**il comprend en outre les étapes suivantes :
- ultérieurement à la gravure (225) de diminution du premier matériau (206), ablation du masque de protection (204) en deuxième matériau par au moins une opération (236) de gravure sélective dudit deuxième matériau ;
- après germination (237), formation (238) d'une couche de semi-conducteur de croissance (220), par croissance latérale (219) sur la surface de la couche de premier matériau (2080) dans la région découverte par ladite ablation (236) du masque de protection (204).

14. Procédé selon l'une quelconque des revendications précédentes, **caractérisé en ce que** le contrôle de la largeur (L070) de la zone de germination (107, 207) comprend un contrôle
- d'une part de la différence de niveaux des surfaces (1060 et 1000, 2060 et 2000) du substrat sous les premier (106, 206) et deuxième matériaux (104, 204), et
- d'autre part de la cinématique d'action de l'opération (128, 225) de gravure chimique sur ledit premier matériau relativement audit deuxième matériaux.

15. Procédé selon l'une quelconque des revendications précédentes, **caractérisé en ce que** le contrôle de la qualité cristalline du semi-conducteur de croissance (110, 210) obtenu comprend un contrôle de la largeur (L070) de la zone de germination (107, 207).

16. Procédé selon l'une quelconque des revendications précédentes, **caractérisé en ce qu'**il comprend les étapes suivantes :
- utilisation d'un procédé du type « LOCal Oxydation of Silicon » pour réaliser une gravure locale d'au moins une zone (105, 205) de silicium à recouvrir de germanium au sein d'un masque définissant un motif (104, 204) sur un substrat (100, 200) de silicium et transformation de la surface de ladite zone (105, 205) en une couche de SiO₂ (106, 206) ;
- attaque ou gravure (128, 225) de ladite couche de SiO₂ (106, 206) en au moins une région incluant un bord de ladite zone à recouvrir (105, 205), jusqu'à découvrir une zone (107, 207) de silicium derrière ladite couche de SiO₂ (106, 206) ;
- utilisation (129, 130, 227, 228) de la zone découverte (107, 207) comme zone de germination pour réaliser une croissance épitaxiale de germanium (109, 209) le long de la surface du SiO₂ (108, 208) subsistant à la surface de ladite zone à recouvrir (105, 205).

17. Procédé selon la revendication 16, **caractérisé en ce qu'**il utilise un substrat déjà modifié selon le procédé « Shallow Trench Isolation », pour réaliser au moins une zone de germanium sur isolant entre deux tranchées d'oxyde de silicium.

18. Procédé selon l'une quelconque des revendications précédentes, **caractérisé en ce que** le semi-conducteur (109, 110, 209, 210) de croissance est du germanium en **en ce que** le procédé il comprend en outre une croissance d'arséniure de gallium sur ledit germanium (110, 210) obtenu.

19. Utilisation du procédé selon l'une quelconque des revendications précédentes pour réaliser un support ou une base (« wafer ») pour la fabrication d'au moins un circuit intégré basé sur le semi-conducteur de croissance (110, 210).

20. Utilisation du procédé selon l'une des revendications 1 à 18 pour réaliser au moins une zone de semi-conducteur de croissance (110, 210) localisée au sein d'un support destiné à servir de base pour la fabrication d'au moins un circuit intégré hétérogène, par création localisée d'au moins une zone de germination (107, 207).

## Patentansprüche

1. Verfahren zum Beschichten einer auf einem Siliziumsubstrat (100, 200) aufgetragenen Schicht eines ersten Materials (108, 208) mit einem sogenannten Wachstumshalbleiter (110, 210), der sich vom Silizium unterscheidet, wobei sich das erste Material von dem Material des Substrats und von dem Wachstumshalbleiter unterscheidet, umfassend:
- mittels mindestens eines Vorgangs des räumlich selektiven Ätzens, Herstellung einer sogenannten Verbundoberflächenschicht auf dem Substrat, umfassend
• mindestens das erste Material (106, 206) in einem ersten Bereich und
• mindestens ein zweites Material (104, 204), das sich vom ersten Material und vom Material des Substrats unterscheidet, in einem zweiten Bereich,
• wobei der erste und der zweite Bereich an mindestens einem Schnittstellenbereich (1070, 2070), der einen Höhenunterschied zwischen der Oberfläche (1060, 2060) des Materials des Substrats (100, 200) in dem ersten Bereich und der Oberfläche (1000, 2000) des Materials des Substrats in dem zweiten Bereich aufweist, aneinander grenzen,
- mindestens einen Vorgang des chemischen Ätzens (128, 225) des ersten Materials (108, 208), bis mindestens ein Teil (107, 207) des Substrats an der Umgebung der Schnittstelle freigelegt wird;
- Wachstum (129, 130) des Wachstumshalbleiters (109, 110) ausgehend von der dadurch freigelegten Stelle (107), dem sogenannten Keimbildungsgebiet.

2. Verfahren nach Anspruch 1, **dadurch gekennzeichnet, dass** das Keimbildungsgebiet (107) mindestens ein Quermaß (L070) kleiner 100 Nanometer aufweist.

3. Verfahren nach einem der vorhergehenden Ansprüche, **dadurch gekennzeichnet, dass** die beiden Bereiche (104, 106) derart verteilt sind, dass sie mindestens einen linearen Schnittstellenbereich aufweisen (1070), welcher vollständig oder teilweise den Umfang eines mit Wachstumshalbleiter zu beschichtenden Bereichs (105) bestimmt.

4. Verfahren nach einem der vorhergehenden Ansprüche, **dadurch gekennzeichnet, dass** ein zu beschichtender Bereich (105, 205) derart ausgewählt wird, dass mindestens ein Keimbildungsgebiet (107, 207) eine senkrecht zur kristallographischen Ausrichtung <110> des Substrats laufenden Längsausrichtung aufweist.

5. Verfahren nach einem der vorhergehenden Ansprüche, **dadurch gekennzeichnet, dass** der Arbeitsschritt (128, 225) zum Ätzen des Schnittstellenbereichs (1070, 2070) so ausgewählt ist, um das erste Material (106, 206) gegenüber dem zweiten Material (104, 204) selektiv zu ätzen.

6. Verfahren nach einem der vorhergehenden Ansprüche, **dadurch gekennzeichnet, dass** es außerdem folgende Arbeitsschritte umfasst:
- Bildung (122-125, 222-223) einer Schicht des zweiten Materials nach einem Teilmuster (104, 204), der sogenannten Schutzmaske, derart ausgewählt, um die Position mindestens eines Keimbildungsgebiets zu bestimmen.
- Bildung (127, 224) einer Schicht (106, 206) des ersten Materials innerhalb des freien Raums (105, 205) der Schutzmaske, sodass die Oberfläche (1060, 2060) des Substrats innerhalb des freien Raums niedriger als die Oberfläche (1000, 2000) des Substrats im mit der Schutzmaske beschichteten Bereich liegt.
- Ätzen (128, 225) des ersten Materials (106, 206) des Schnittstellenbereichs (1070, 2070), bis die darunterliegende Oberfläche des Substrats an mindestens einem konzentrierten Bereich freigelegt wird und somit ein Keimbildungsgebiet (107, 207) am Rande der Schutzmaske (104, 204) bildet.

7. Verfahren nach einem der vorhergehenden Ansprüche, **dadurch gekennzeichnet, dass** das Substrat (100, 200, 500) Silicium ist.

8. Verfahren nach einem der vorhergehenden Ansprüche, **dadurch gekennzeichnet, dass** der Wachstumshalbleiter (109, 110, 209, 210) Germanium oder Galliumsarsenid oder Indiumphosphid ist.

9. Verfahren nach einem der Ansprüche 7 oder 8, **dadurch gekennzeichnet, dass** die Bildung des ersten Materials (108, 208) eine Umwandlung (127, 224) der Oberfläche eines Siliziumsubstrats (100, 200) in ein SiO₂ enthaltendes, isolierendes Material (100, 200) in mindestens einem Bereich (105, 205) umfasst.

10. Verfahren nach einem der vorhergehenden Ansprüche, **dadurch gekennzeichnet, dass** die Bildung des zweiten Materials (102, 202) eine Abscheidung (121, 221) von Si₃N₄ umfasst.

11. Verfahren nach einem der vorhergehenden Ansprüche, **dadurch gekennzeichnet, dass** es außerdem folgende Arbeitsschritte umfasst:
- Bildung (121) einer sogenannten Schutzschicht (102) aus zweitem Material auf einem Siliziumsubstrat (100);
- selektives Ätzen (122-125) der Schutzschicht (102) zur Herstellung einer Schutzmaske (104), die das Silizium (100) in mindestens einem Bereich (105) zu Tage treten lässt, der mit dem Wachstumshalbleiter (106) beschichtet werden soll;
- oberflächliche Wandlung (127) des Siliziums an der Oberfläche des zu beschichtenden Bereichs (105) in eine Schicht (106) aus erstem, SiO₂ enthaltenden Material;
- Angriff oder isotropes Ätzen (128) des SiO₂ (106) mindestens eines Schnittstellenbereichs zwischen der Schutzmaske (104) und dem ersten Material (106) des zu beschichtenden Bereichs, (105) bis ein Siliziumbereich (107) hinter dem ersten Material freigelegt wird;
- Keimbildung und epitaktische Wachstum (129, 130) einer Schicht (110) von Wachstumshalbleiter anhand des freigelegten Siliziumbereichs (107).

12. Verfahren nach einem der vorhergehenden Ansprüche 1-11, **dadurch gekennzeichnet, dass** es außerdem folgende Arbeitsschritte umfasst:
- Bildung (221) einer Schicht (201) von erstem, SiO₂ enthaltenden Material auf der Oberfläche eines Siliziumsubstrats (200);
- Bildung (221) einer sogenannten Schutzschicht (202) aus zweitem Material auf der Schicht (201) von erstem Material;
- räumlich selektives Ätzen (222) der Schutzschicht (202) zur Herstellung einer Schutzmaske (204), die das Silizium des Substrats (200) in mindestens einem Bereich (205) zu Tage treten lässt, welcher mit dem Wachstumshalbleiter beschichtet werden soll;
- oberflächliche Wandlung (224) des Siliziums an der Oberfläche des zu beschichtenden Bereichs (205) in eine Schicht (206) von erstem, SiO₂ enthaltenden Material;
- Angriff oder Ätzen (128) des SiO2 (206) mindestens eines Schnittstellenbereichs zwischen der Schutzmaske (204) und dem ersten Material (206) des zu beschichtenden Bereichs (205), bis ein Siliziumbereich (207) hinter dem ersten Material (206) freigelegt wird;
- Keimbildung und epitaktische Wachstum (227, 228) einer Schicht (210) von Wachstumshalbleiter anhand des erschienenen Siliziumbereichs (207).

13. Verfahren nach Anspruch 12, **dadurch gekennzeichnet, dass** es außerdem folgende Arbeitsschritte umfasst:
- nach dem Ätzen (225) zur Reduzierung des ersten Materials (206), Entfernung der Schutzschicht (204) aus zweitem Material durch mindestens einen Vorgang (236) des selektiven Ätzens des zweiten Materials;
- nach Keimbildung (237), Bildung (238) einer Schicht von Wachstumshalbleiter (220) durch seitliche Wachstum (219) auf der Oberfläche der ersten Schicht von erstem Material (2080) in dem durch die Entfernung (236) der Schutzschicht (204) freigelegten Bereich.

14. Verfahren nach einem der vorhergehenden Ansprüche, **dadurch gekennzeichnet, dass** die Kontrolle der Breite (L070) des Keimbildungsgebiets (107, 207) eine Kontrolle
- einerseits des Höhenunterschieds der Oberflächen (1060 und 1000, 2060 und 2000) des Substrats unter dem ersten (106, 206) und dem zweiten Material (104, 204), und
- andererseits der Bewegungskinematik des Vorgangs (128, 225) zum chemischen Ätzen auf dem ersten Material im Vergleich zu dem zweiten Material umfasst.

15. Verfahren nach einem der vorhergehenden Ansprüche, **dadurch gekennzeichnet, dass** die Kontrolle der kristallinen Güte des gewonnenen Wachstumshalbleiters (110, 210) eine Kontrolle der Breite (L070) des Keimbildungsgebiets (107, 207) umfasst.

16. Verfahren nach einem der vorhergehenden Ansprüche, **dadurch gekennzeichnet, dass** es außerdem folgende Arbeitsschritte umfasst:
- Anwendung eines Verfahrens vom Typ "LOCal Oxydation of Silicon" zur Ausführung eines lokalen Ätzens mindestens eines Siliziumbereichs (105, 205), das mit Germanium innerhalb einer Schutzmaske zu beschichten ist, welche ein Muster (104, 204) auf einem Siliziumsubstrat (100, 200) bestimmt, und Umwandlung der Oberfläche des Bereichs (105, 205) in eine Schicht von SiO₂ (106, 206);
- Angriff oder Ätzen (128, 225) der Schicht von SiO2 (106, 206) an mindestens einem Bereich, der einen Rand des zu beschichtenden Bereichs (105, 205) einschließt, bis ein Siliziumbereich (107, 207) hinter der Schicht von SiO₂ (106, 206) freigelegt wird;
- Verwendung (129, 130, 227, 228) des freigelegten Bereichs (107, 207) als Keimbildungsgebiet zur epitaktischen Wachstum von Germanium (109, 209) entlang der Oberfläche des SiO₂ (108, 208), das an der Oberfläche des zu beschichtenden Bereichs (105, 205) bleibt.

17. Verfahren nach Anspruch 16, **dadurch gekennzeichnet, dass** es ein nach dem Verfahren "Shallo Trench Isolation" bereits modifiziertes Substrat zur Herstellung mindestens eines Germaniumbereichs auf Isolierstoff zwischen zwei Gräben von Siliziumoxyd verwendet.

18. Verfahren nach einem der vorhergehenden Ansprüche, **dadurch gekennzeichnet, dass** der Wachstumshalbleiter (109, 110, 209, 210) Germanium ist, und dadurch, dass das Verfahren außerdem eine Wachstum von Galliumsarsenid auf dem gewonnenen Germanium (110, 210) umfasst.

19. Anwendung des Verfahrens nach einem der vorhergehenden Ansprüche zur Herstellung eines Trägers oder eines Wafers zur Herstellung mindestens eines integrierten Schaltkreises mit dem Wachstumshalbleiter (110, 210) als Wafer.

20. Anwendung des Verfahrens nach einem der Ansprüche 1-18 zur Herstellung mindestens eines lokalen Wachstumshalbleiterbereichs (110, 210) innerhalb eines Trägers, der als Wafer für die Herstellung mindestens eines heterogenen integrierten Schaltkreises durch lokalisierte Erzeugung mindestens eines Keimbildungsgebiets (107, 207) dienen soll.

## Claims

1. Method for covering a layer of a first material (108, 208) supported by a silicon substrate (100, 200) using a thus named grown semiconductor (110, 210) different from silicon, said first material being different from the material of the substrate and different from the grown semiconductor, said method comprising:
- using at least one operation of spatially selective etching, producing on said substrate a surface layer called composite, comprising
• at least said first material (106, 206) in a first region and
• at least a second material (104, 204), different from the first material and different from the material of the substrate, in a second region,
• said first and second regions being contiguous (1071) in at least an interface area (1070, 2070) having a difference in level between the surface (1060, 2060) of the material of said substrate (100, 200) in said first region and the surface (1000, 2000) of the material of said substrate in said second region;
- at least one operation of chemical etching (128, 225) of said first material (108, 208) until at least a portion (107, 207) of the substrate is exposed around said interface;
- growth (129, 130) of said grown semiconductor (109, 110) from the portion thus exposed (107), called the germination area.

2. Method according to claim 1, **characterized in that** the germination area (107) has at least one transverse dimension (L070) having a value of less than one hundred nanometres.

3. Method according to one of the preceding claims, **characterized in that** the two regions (104, 106) are distributed so as to have at least one linear interface area (1070) delimiting entirely or partially the perimeter of a region (105) to be covered by grown semiconductor.

4. Method according to any one of the preceding claims, **characterized in that** an area to be covered (105, 205) is chosen so that at least one germination area (107, 207) has a longitudinal direction perpendicular to the crystallographic direction <110> of the substrate.

5. Method according to any one of the preceding claims, **characterized in that** the step (128, 225) of etching the interface area (1070, 2070) is chosen to etch the first material (106, 206) selectively with respect to the second material (104, 204).

6. Method according to any one of the preceding claims, **characterized in that** it comprises the following steps:
- formation (122 - 125, 222 - 223) of a layer of second material according to a partial pattern (104, 204), called a protective mask, chosen to determine the position of at least one germination area;
- formation (127, 224) of a layer (106, 206) of first material inside the open space (105, 205) in said protective mask, so that the surface (1060, 2060) of the substrate inside said open space is situated lower than the surface (1000, 2000) of the substrate in the region covered by the protective mask;
- etching (128, 225) of the first material (106, 206) of the interface area (1070, 2070) until the underlying surface of the substrate is exposed in at least one localized area, thus forming a germination area (107, 207) at the edge of said protective mask (104, 204).

7. Method according to any one of the preceding claims, **characterized in that** the substrate (100, 200, 500) is silicon.

8. Method according to any one of the preceding claims, **characterized in that** the grown semiconductor (109, 110, 209, 210) is of germanium, or gallium arsenide, or indium phosphide.

9. Method according to one of claims 7 or 8, **characterized in that** the formation of the first material (108, 208) comprises a transformation (127, 224) of the surface of a silicon substrate (100, 200), in at least one region (105, 205), into an insulating material comprising SiO₂.

10. Method according to any one of the preceding claims, **characterized in that** the formation of the second material (102, 202) comprises a deposition (121, 221) of Si₃N₄.

11. Method according to any one of the preceding claims, **characterized in that** it comprises the following steps:
- formation (121) of a thus named protective layer (102) of second material on a silicon substrate (100);
- selective etching (122 to 125) of the protective layer (102) to produce a protective mask (104) allowing the silicon (100) to appear in at least one area (105) intended to be covered by the grown semiconductor (106);
- superficial transformation (127) of the silicon of the surface of said area to be covered (105) into a layer (106) of first material comprising SiO₂;
- isotropic attack or etching (128) of the SiO₂ (106) of at least one interface area between the protective mask (104) and the first material (106) of said area to be covered (105), until a silicon area (107) is exposed behind said first material;
- epitaxial germination and growth (129, 130) of a layer (110) of grown semiconductor from the exposed silicon area (107).

12. Method according to any one of claims 1 to 11, **characterized in that** it comprises the following steps:
- formation (221) of a layer (201) of first material comprising SiO₂ on the surface of a silicon substrate (200);
- formation (221) of a thus named protective layer (202) of second material on the layer (201) of first material;
- spatially selective etching (222) of the protective layer (202) in order to produce a protective mask (204) allowing the silicon substrate (200) to appear in at least one area (205) intended to be covered by the grown semiconductor;
- superficial transformation (224) of the silicon at the surface of said area to be covered (205) into a layer (206) of first material comprising SiO₂;
- attack or etching (128) of the SiO₂ (206) of at least one interface area between the protective mask (204) and the first material (206) of said area to be covered (205), until a silicon area (207) is exposed behind said first material (206);
- epitaxial germination and growth (227, 228) of a layer (210) of grown semiconductor from said exposed silicon area (207).

13. Method according to claim 12, **characterized in that** it also comprises the following steps:
- subsequent to the reduction etch (225) of the first material (206), ablation of the protective mask (204) of second material by at least one operation of selective etching (236) of said second material;
- after germination (237), formation (238) of a layer of grown semiconductor (220), by lateral growth (219) on the surface of the layer of first material (2080) in the region exposed by said ablation (236) of the protective mask (204).

14. Method according to any one of the preceding claims, **characterized in that** control of the width (L070) of the germination area (107, 207) comprises control
- on the one hand of the difference in levels of the surfaces (1060 and 1000, 2060 and 2000) of the substrate beneath the first (106, 206) and second materials (104, 204), and
- on the other hand the action kinematics of the chemical etching operation (128, 225) on the first material relative to the second material.

15. Method according to any one of the preceding claims, **characterized in that** control of the crystalline quality of the grown semiconductor (110, 210) obtained comprises a control of the width (L070) of the germination area (107, 207).

16. Method according to any one of the preceding claims, **characterized in that** it comprises the following steps:
- use of a method of the "LOCal Oxidation of Silicon" type in order to produce a local etching of at least one silicon area (105, 205) to be covered with germanium within a mask defining a pattern (104, 204) on a silicon substrate (100, 200) and transformation of the surface of said area (105, 205) into a layer of SiO₂ (106, 206);
- attack or etching (128, 225) of said layer of SiO₂ (106, 206) in at least one region including an edge of said area to be covered (105, 205) until a silicon area (107, 207) is exposed behind said layer of SiO₂ (106, 206);
- use (129, 130, 227, 228) of the exposed area (107, 207) as a germination area in order to produce an epitaxial growth of germanium (109, 209) along the surface of the SiO₂ (108, 208) remaining on the surface of said area to be covered (105, 205).

17. Method according to claim 16, **characterized in that** it uses a substrate already modified according to the "Shallow Trench Isolation" method in order to produce at least one area of germanium over insulation between two trenches of silicon oxide.

18. Method according to any one of the preceding claims, **characterized in that** the grown semiconductor (109, 110, 209, 210) is germanium and **in that** the method also comprises growing gallium arsenide on said germanium (110, 210) obtained.

19. Use of the method according to any one of the preceding claims in order to produce a support or a base ("wafer") for the manufacture of at least one integrated circuit based on the grown semiconductor (110, 210).

20. Use of the method according to one of claims 1 to 18 in order to produce at least one grown semiconductor area (110, 210) located within a support intended to serve as a base for the manufacture of at least one heterogeneous integrated circuit by localized creation of at least one germination area (107, 207).
